# EUROPEAN PATENT APPLICATION

(11) **EP 2 141 736 A1**
(43) Date of publication of application: **06.01.2010**
(21) Application number: 08740410.9
(22) Date of filing: 15.04.2008
(51) Int. Cl.: H01L 21/301, C09J 7/02, C09J 201/00

(54) **PRESSURE-SENSITIVE ADHESIVE SHEET FOR WATER JET LASER DICING**

(30) Priority: 20.04.2007 JP 2007111108
(71) Applicant: Nitto Denko Corporation, Ibaraki-shi Osaka 567-8680 (JP)
(72) Inventor: TAKAHASHI, Tomokazu, Ibaraki-shi Osaka 567-8680 (JP); ASAI, Fumiteru, Ibaraki-shi Osaka 567-8680 (JP); SHINTANI, Toshio, Ibaraki-shi Osaka 567-8680 (JP); SASAKI, Takatoshi, Ibaraki-shi Osaka 567-8680 (JP); YAMAMOTO, Akiyoshi, Ibaraki-shi Osaka 567-8680 (JP); MIKI, Tsubasa, Ibaraki-shi Osaka 567-8680 (JP)
(74) Representative: Schaeberle, Steffen
(86) International application number: PCT/JP2008/057324
(87) International publication number: WO 2008/133104

(57) **Abstract**

An object of the present invention is to provide an adhesive sheet which, through improvement in the permeability of liquids originating in a liquid stream during water jet laser dicing, allows chips, IC components, or the like to be detached, prevents machining precision from being compromised such as by chipping or the scattering of chips and the like, and allows extremely thin semiconductor wafers or materials to be processed. The adhesive sheet for water jet laser dicing of the present invention comprises an adhesive layer laminated on a base film, the base film made of mesh fiber.

## Description

### BACKGROUND OF THE INVENTION

### Field of the Invention

The present invention relates to an adhesive sheet for water jet laser dicing, and more particularly relates to an adhesive sheet for water jet laser dicing used to fix a semiconductor wafer and/or a semiconductor-related material during dicing with a water jet laser.

### Background Information

The conventional practice has been to use a rotary blade to cut semiconductor wafers, semiconductor-related materials and the like, and separate them into chips and IC parts. In this dicing step, the semiconductor wafer or the like is usually first affixed with an adhesive tape. After the semiconductor wafer or the like has been cut into chips, they are removed from the adhesive tape by a pick-up.
However, physical stress produced by the dicing blade can cause die fly-off, or cracking, chipping and other such defects in the chips and the like cut by this method, which lowers the quality of the chips and the like, and also lowers the productivity of this cutting method. In particular, this problem has become more serious as there has been greater demand for even smaller and thinner electronic devices in recent years.

In view of this, a dicing method that makes use of a laser beam, and particularly a method for processing materials by cutting, perforating, welding, stamping, peeling, or the like using a laser beam guided by a liquid jet, has been proposed as an alternative to techniques for cutting semiconductor wafers and the like with a dicing blade (see, Patent publication 1 for example). With this method, the wafer or the like is merely exposed to a water jet from above, which prevents die fly-off and the like caused by the physical stress produced by a rotating blade.

Also, with a cutting method that makes use of this laser technique, the use of a water jet can be a problem in that it makes the chips or the like more susceptible to coming loose from the adhesive tape that fixes them, and in an effort to deal with this, an adhesive tape has been proposed that can be used preferably in water jet laser dicing (see Patent publication 2, for example).
[Patent publication 1] WO95/32834
[Patent publication 2] Japanese Laid-Open Patent Application 2001-316648

### PROBLEMS TO BE RESOLVED BY THE INVENTION

An object of the present invention is to provide an adhesive sheet which, through improvement in the permeability of liquids originating in a liquid stream during water jet laser dicing, allows chips, IC components, or the like to be detached, prevents machining precision from being compromised such as by chipping or the scattering of chips and the like, and allows extremely thin semiconductor wafers or materials to be processed.

### SUMMARY OF THE INVENTION

An adhesive sheet for water jet laser dicing of the present invention, comprising an adhesive layer laminated on a base film, (1) the base film has a perforation, and the adhesive layer has a thickness of 0.1 to 20µm, (2) the adhesive layer had a tensile strength of 1 MPa or more, and/or (3) the adhesive layer has an angle of contact of water of no more than 90 degrees relative to the surface thereof.
In this adhesive sheet for water jet laser dicing, the adhesive is preferably a type that is cured by an energy radiation.
Further the base film is preferably a mesh film.

### EFFECT OF THE INVENTION

According to the adhesive sheet for water jet laser dicing in the present invention, a base film having perforations is used, and an adhesive layer of a certain thickness is provided, or the adhesive layer has a tensile strength of no more than 1 MPa, or water has an angle off contact of no more than 90 degrees relative to the surface of the adhesive layer, thus ensuring that liquids originating in a liquid stream during water jet laser dicing can readily break up the adhesive layer and smoothly penetrate through the perforations of the base film. This can prevent the material that is being processed from falling off the adhesive sheet while being diced with liquids. As a result, machining precision can be prevented from being compromised such as by chipping or the scattering of chips or the like, and extremely thin semiconductor wafers and the like can be processed.

### DETAILED DESCRIPTION OF THE PREFERRED EMBODIMENTS

The adhesive sheet for water jet laser dicing of the present invention mainly comprises a base film and an adhesive layer disposed on this base film. The phrase "adhesive sheet for water jet laser dicing" here refers to an adhesive sheet that is used in dicing with a laser beam guided by a liquid jet (usually a water jet), and with which the liquid used in this liquid jet during dicing, such as a liquid jet with at least a specific pressure, and the liquid that is applied directly or indirectly from the adhesive layer side can escape from one side of the adhesive sheet to the other side. The specific pressure here is usually about a few MPa or higher.

Examples of the base film include non-woven, woven (i.e., mesh film) and the like made of a film or a fiber. Examples of the film include a synthetic resin, for example, polyolefins such as polyethylene, polypropylene (e.g., low-density polyethylene, liner low-density polyethylene, high-density polyethylene, drawn polypropylene, non-drawn polypropylene, ethylene-polypropylene copolymer, ethylene-vinyl acetate copolymer, ethylene-(meth)acrylic acid copolymer, ethylene-(meth)acrylic ester copolymer and the like), polyester, polyethylene terephthalate, polyurethane, EVA, polytetrafluoroethylene, polyvinyl chloride, polyvinylidene chloride, polyamide, acetal resin, polystyrene, polysulfone, polycarbonate, nylon, fluorocarbon polymer; rubber-containing polymer such as styrene-butadiene copolymer. Examples of the fiber include a polymer fiber such as PP, PVC, PE, PU, PS, PO, PET and the like; a synthetic fiber such as rayon, acetylcellulose and the like; a natural fiber such as cotton, silk, wool and the like; an inorganic fiber such as glass fiber, carbon fiber and the like. Among these, the base film is preferably formed of a polyolefin or includes a layer composed of a polyolefin. As a result, both adequate strength and expandability for laser dicing can be ensured for the adhesive sheet. From another standpoint, the base film is preferably a mesh film. This can ensure that liquids originating in a liquid stream are more readily drained off.

The base film may be single layer or multilayer of more than two layers. The fibers may be either monofilaments or multifilaments when the base film is formed of fiber. Monofilaments are preferred in order to make the mean opening diameter of the base film more uniform described below.

The base film has at least one perforation. The perforation preferably passes through in the thickness direction, but numerous perforations may be joined, resulting in perforations that are linked in the thickness direction. In particular, the perforation of the base film is preferably the kind of opening obtained when the base film is composed of a mesh structure. The porosity of the base film is preferably about 3 to 90 %, and when the base film is composed of a mesh structure, the mean opening diameter is preferably about 5 to 800 µm, about 5 to 150 µm, about 5 to 100 µm, and about 5 to 50 µm. This is because the enough adhesiveness of the base film to the adhesive by ensuring contact area with the adhesive and the evenness of the adhesive layer surface can be ensured. Also, this prevents the material that is being processed from falling off and the like by passing more readily water used at water jet laser dicing. As used here, the mean opening diameter means the diameter when the perforation is generally round, and means the length on one side when the perforation has a polygonal shape or the like. From another standpoint, the perforation size may suitable be, for example, about 10 µm² to 3.0 mm², preferably about 25 µm² or more, about 100 µm² or more, about 1000 µm² or more, about 0.1 mm² or more, and about 3.0 mm² or less, about 2.0 mm² or less, about 1.1 mm² or less, about 900 µm² or less.

To make the base film into a mesh structure, for example, the fiber diameter is preferably about 10 to 150 µm, and even more preferably about 25 to 80 µm from the standpoint of liquid permeability.
The thickness of the base film is generally 10 to 400 µm, preferably 30 to 250 µm, for avoiding fracture of the sheet or breaking during processing the semiconductor wafer or the like as well as decreasing manufacturing cost.

The base film may be subjected to surface treatment, such as corona discharge treatment, flame treatment, plasma treatment, sputter etching treatment, undercoating (e.g., primer), fluorine treatment; or degreasing treatment using a chemical solution on the surface thereof on which the adhesive film is formed, for the enhancement of the adhesiveness to the adhesive film. Applying a primer is especially preferable.

The base film of the present invention preferably has a fracture elongation of over 100%, and more preferably 150%. This is because stretching the adhesive sheet makes it possible for the chips or the like to be easily picked up from the adhesive sheet after the dicing step.
Furthermore, the base film preferably has a tensile strength of over 0.1 N/20 mm, more preferably over 0.3 N/20 mm. The reason for this is to avoid breaking and/or cutting the adhesive sheet itself.

The fracture elongation and tensile strength can be measured, for example, with a tensile tester using a sample with a length of 5.0 cm and a width of 20 mm. The tensile speed during the test is 300 mm/minute at room temperature (according to ASTM D1000). The fracture elongation can be calculated as follows.
Fracture Elongation (%) = (Length at fracturing - Original Length) ö (Original Length) × 100
The tensile strength is a value at fracturing.

The adhesive layer comprises an adhesive coated on one side of the base film. This adhesive may be any type of pressure sensitive, heat-sensitive, photosensitive, but it is suitably a type that is cured by an energy radiation, because this allows the layer to be easily removed from the workpiece. The energy radiation used here can be radiation of various wavelengths, such as ultraviolet rays, visible light rays, or infrared rays, but since the laser beam used for dicing is one with an oscillation wavelength less than 400 nm, such as a third or fourth harmonic of a YAG laser with an oscillation wavelength of 355 nm or 266 nm, XeCI excimer laser with an oscillation wavelength of 308 nm, or KrF excimer laser with an oscillation wavelength of 248 nm, or one with an oscillation wavelength of 400 nm or more, such as a titanium sapphire laser with a wavelength near 750 to 800 nm, which allows light absorption in the UV band via a multi-photon absorption process, which allows cutting at a width of 20 µm or less by multi-photon absorption ablation, and which has a pulse width of 1 e⁻⁹ second or less (0.000000001 second), it is preferable to use an adhesive that will not be cured by a irradiation with the laser beam of the dicing apparatus being used.

A known adhesive including (meth)acrylic polymers and rubber-based polymers can be used as the material that forms the adhesive layer, but a (meth)acrylic polymer is particularly preferable. This is because even when a photosensitive adhesive is formed, it can be cured without adding any special monomer/oligomer component or the like for an energy radiation curing.

Examples of rubber-based polymers include natural rubbers, such as polyisoprene; and synthetic rubbers, such as styrene-butadiene rubber or a rubber based on polybutadiene, butadiene-acrylonitrile, chloroprene and the like.

Examples of a monomer component of (meth)acrylic polymers include alkyl acrylates and alkyl methacrylates having linear or branched alkyl groups with 30 or fewer carbons, and preferably 4 to 18 carbons, such as methyl, ethyl, n-propyl, isopropyl, n-butyl, t-butyl, isobutyl, amyl, isoamyl, hexyl, heptyl, cyclohexyl, 2-ethylhexyl, octyl, isooctyl, nonyl, isononyl, decyl, isodecyl, undecyl, rauryl, tridecyl, tetradecyl, stearyl, octadecyl, and dodecyl. These alkyl (meth)acrylates can be used alone or as mixture of more than two components.

Examples of a monomer component other than the above monomers include carboxyl-containing monomer such as acrylic acid, methacrylic acid, carboxyethyl (meth)acrylate, carboxypentyl (meth)acrylate, itaconic acid, maleic acid, fumaric acid, and crotonic acid; acid anhydride monomer such as maleic anhydride, itaconic anhydride; hydroxyl group-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, 4-hydroxymethyl cyclohexyl methyl(meth)acrylate; sulfonate-containing monomer such as styrenesulfonate, allylsulfonate, 2-(meth) acrylamide-2-methyl propanesulfonate, (meth)acrylamide propanesulfonate, sulfopropyl (meth)acrylate, (meth)acryloyl oxynaphthalenesulfonate; phosphate-containing monomer such as 2-hydroxyethyl acryloylphosphate; (meth)acrylamide; N-hydroxymethylamide (meth)acrylate; alkylamino alkylester(meth)acrylate such as dimethylamino ethylmethacrylate, t-butylamino ethylmethacrylate; N-vinylpyrrolidone; acryloyl morpholine; vinyl acetate; styrene; acrylonitrile and the like. These monomer components can be used alone or as mixture of more than two components.

Multifunctional monomers may be used as needed for the purpose of crosslinking (meth)acrylic polymer. Examples of the multifunctional monomer include hexanediol di(meth)acrylate, (poly)ethylene glycol di(meth)acrylate, (poly)propylene glycol di(meth)acrylate, neopentylglycol di(meth)acrylate, pentaerythritol di(meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate and the like. These multifunctional monomer components can be used alone or as mixture of more than two components. From the standpoint of adhesion characteristic and the like, the amount in which the multifunctional monomers are contained is preferably no more than 30 wt%, more preferably no more than 20 wt% of the total monomer component.

It is even more preferable to use a monomer and/or oligomer having an energy radiation curable functional group, such as a carbon-carbon double bond.
Examples of the monomer and/or oligomer include urethane (meth)acrylate, trimethylolpropane tri(meth)acrylate, tetramethylolmethan tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butylene glycol di(meth)acrylate and the like. These components can be used alone or as mixture of more than two components. There are no particular restrictions on the amount in which these are contained, but from the standpoint of adhesion characteristic, about 5 to 500 weight parts, or about 70 to 150 weight parts per 100 weight parts of the (meth)acrylic polymer or other base polymer of the adhesive is preferable.

It is preferable to use a photopolymerization initiator when a photosensitive adhesive is formed. Examples of the photopolymerization initiator include acetophenone compounds such as 4-(2-hydroxyethoxy) phenyl(2-hydroxy-2-propyl) ketone, α-hydroxy-α,α-methyl acetophenone, methoxy acetophenone, 2,2-dimethoxy-2-phenyl acetophenone, 2,2-diethoxy-acetophenone, 1-hydroxycyclohexyl phenyl ketone, 2-methyl-1-[4-(methyltio)phenyl]-2-morpholinoprophane-1; benzoine ether compounds such as benzoine ethyl ether, benzoine isopropyl ether, anisoin methyl ether; α-ketol compounds such as 2-methyl-2-hydroxypropylphenon; ketal compounds such as benzyldimethyl keral; aromatic sulfonyl chloride compounds such as 2-naphthalene sulfonyl chloride; light-active oxime compounds such as 1-phenon-1,1-propanedione-2-(o-ethoxycarbonyl) oxime; benzophenone compounds such as benzophenone, benzoylbenzoate, 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone; camphor chinone; ketone halide; acyl phosphinoxide; acyl phosphonate and the like. These components can be used alone or as mixture of more than two components. The amount in which the photopolymerization initiators are contained, about 0.1 to 10 weight parts, or about 0.5 to 5 weight parts per 100 weight parts of the base polymer of the adhesive is preferable.

A crosslinking agent may also be added to raise the weight average molecular weight of the base polymer. Examples of the crosslinking agent include polyisocyanate compounds, epoxy compounds, aziridine compounds, melamine resins, urea resins, anhydrous compounds, polyamines, carboxyl group-containing polymers and the like. These can be used alone or as mixture of more than two compounds. When a crosslinking agent is used, it is generally preferable for it to be used in an amount of about 0.01 to 5 weight parts per 100 weight parts base polymer so that the peeling-off adhesion strength will not decrease too much.

In addition to the above components, the adhesive may optionally comprise any conventional additive such as tackifiers, antioxidants, fillers, antioxidants, pigments and the like.
The acrylic polymer can be prepared, for example, by applying a known method such as solution polymerization, emulsion polymerization, mass polymerization, suspension polymerization to one or more kinds of monomer or a mixture thereof. Among these, solution polymerization is preferable. Examples of solvents that can be used include ethyl acetate, toluene and other such polar solvents. The solution concentration is usually about 20 to 80 wt%.

A polymerization initiator may be used in the preparation of the polymer. Examples of the polymerization initiator include peroxides such as hydrogen peroxide, benzoyl peroxide, t-butyl peroxide, and the like. One may be used by itself, or it may be combined with a reducing agent and used as a redox type of polymerization initiator. Examples of the reducing agent include ionic salts such as salts of iron, copper, cobalt, sulfite, bisulfite; amines such as triethanol amine; reducing sugar such as aldose, ketose and the like. Also, azo compounds such as 2,2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used alone or as mixture of more than two components.

The reaction temperature is usually about 50 to 85°C, and the reaction time about 1 to 8 hours.
From the standpoint of preventing fouling of the workpiece and the like, it is preferable for the acrylic polymer to have a low content of low-molecular weight substances, and for the acrylic polymer to have a number average molecular weight of at least 300,000, particularly at a rage of about 800,000 to 3,000,000.

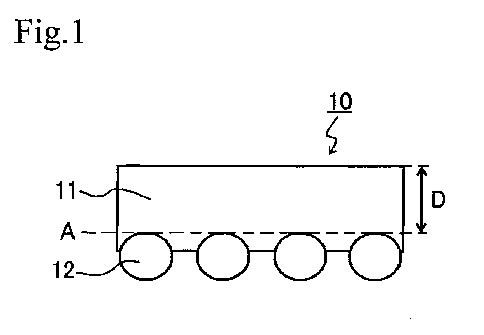

The adhesive layer can be adjusted to the desired thickness within a range that will not result in the layer becoming detached from the material that is processed but is preferably about 0.1 µm to 20 µm in the interests of ensuring enough adhesive strength to make sure that the material being processed is secured during the dicing process, preventing undesirable adhesive residue on the back surface of semiconductor wafers or the like after the wafers or the like have been removed from the sheet, allowing water to break up and there by penetrate the adhesive layer, minimizing adhesive layer resonance caused by vibration from the liquid stream or the irradiation of the laser beam during the dicing process, controlling the vibration amplitude, and preventing chips from cracking, chipping, and the like. Here, the thickness of the adhesive layer usually means the valued determined by subtracting the thickness of the base film from the overall thickness of the adhesive sheet. As illustrated in FIG. 1, when the base film 12 forming the adhesive sheet 10 is a mesh film, the uppermost surface of the base film 12 is the thickness baseline A, and the length from the thickness baseline A to the uppermost surface of the adhesive layer 11 is defmed as the thickness D of the adhesive layer.

In the present invention, the tensile strength of the adhesive layer is also preferably no more than 1 MPa. Establishing this tensile strength will allow the adhesive layer to be readily broken up by the liquid stream and will ensure that liquids originating in the liquid stream, that is, the water, can be drained off. The tensile strength can be adjusted as desired by means of the components of the adhesive that is used, such as by adjusting the proportion of multisensitive monomer and/or cross linker. The tensile strength can be determined by methods noted above, for example.
Furthermore, water will preferably have an angle of contact of no more than 90 degrees relative to the surface of the adhesive layer. Such an angle of contact will result in good water wettability and will ensure that liquids originating in the liquid stream can be readily drained from the other side of the adhesive sheet.

A suitable selection of the materials noted above will preferably be combined to produce the adhesive layer in order to ensure that water has an angle of contact of no more than 90 degrees. For example, the use of monomer/oligomer components with polar groups is preferred. Examples of polar groups include amino groups, amide groups, alkoxy groups, hydroxyl groups, ester groups, cyano groups, nitro groups, and carbonyl groups. The types of polar groups, the proportions in which they are introduced, and the like are preferably adjusted as desired in consideration of storage/stability, etc., in addition to the types, amounts, and the like of the other components of the adhesive.

The adhesive sheet of the present invention can be formed by a tape manufacturing method known in this field of technology. For example, the base film is provided first. The adhesive, then, may be laminated onto the base film. The base film may be coated directly, or a transfer coating process may be employed in which a process material coated with a release agent is coated with the adhesive and dried, after which the adhesive is laminated to the base film, or the adhesive may be laminated in a rolling mill on the base film. These coating process can be performed by any existing coating method, for example, reverse roll coating, gravure coating, curtain spray coating, die coating, extrusion and other industrially applied coating methods may be used.
The base film that is prepared may have perforations already in the base film, or the perforations may be formed after the base film has been coated with the adhesive.

The adhesive sheet of the present invention has an adhesive strength of 1.5 N/20 mm or more, preferably 3 N/20 mm or more, and less than 10 N/20 mm, preferably less than 8 N/20 mm. In other words, along with changes in dicing technology to technology involving the use of a water jet laser, the critical significance of the adhesive strength of an adhesive sheet used for dicing is also changing, and as a result, good adhesion with the wafer or the like during dicing can be ensure even at a weaker adhesive strength, and chips or parts can be prevented from coming loose from the adhesive tape. In addition, a reduction in the initial adhesive strength allows chipping and other such defects to chips, IC parts, and the like during pick-up to reduce. In particular, in the case of a photosensitive adhesive, the adhesive strength of the adhesive after irradiation can be effectively, quickly, and easily reduced. The adhesive strength after irradiation is preferably less than 0.2 N/20 mm, more preferably less than 0.18 N/20 mm.
Here, an adhesive strength is the value which is measured on an Si-mirror wafer under the conditions of 23 ± 3 °C, 180 ° peeling angle and a peeling speed of 300 mm/min (according to ASTM D1000).

Examples of the adhesive sheet for water jet laser dicing of the present invention will now be described in detail.

### (Preparation of base film)

Polyethylene terephthalate fiber with a fiber diameter of 55 µm was used to form a 90 µm thick mesh film with a density of 200 × 200/inch and a void area of 32%. Mesh film which had undergone corona treatment was used as the base film.

### Example 1

40 weight parts methyl acrylate, 35 weight parts 2-ethylhexyl acrylate, 20 weight parts acryloyl morpholine, and 5 weight parts of acrylic acid were copolymerized by a standard method in ethyl acetate to obtain a solution containing an acrylic copolymer with a weight average molecular weight of 600,000.
To this solution containing the acrylic copolymer were added 100 weight parts UV-curing oligomer (viscosity of 10 Pa·sec at 25 °C) that was obtained by reaction of pentaerythritol triacrylate and diisocyanate, 3 weight parts photopolymerization initiator (trade name "Irgacure 651," made by Ciba Specialty Chemicals), and 2 weight parts polyisocyanate compound (trade name "Coronate L," made by Nippon Polyurethane Industry), which gave a UV-curing acrylic adhesive solution.
The resulting UV curable adhesive solution was coated to an adhesive layer thickness of 5 µm on the above base film, giving an adhesive sheet.

### Example 2

An adhesive sheet was obtained in the same manner as in Example 1 except that the UV curable adhesive solution was coated to an adhesive layer thickness of 15 µm.

### Example 3

60 weight parts methyl acrylate, 35 weight parts 2-methoxyethyl acrylate, and 5 weight parts of acrylic acid were copolymerized by a standard method in ethyl acetate to obtain a solution containing an acrylic copolymer with a weight average molecular weight of 700,000.
To this solution containing the acrylic copolymer were added 100 weight parts UV-curing oligomer (viscosity of 10 Pa·sec at 25 °C) that was obtained by reaction of pentaerythritol triacrylate and diisocyanate, 3 weight parts photopolymerization initiator (trade name "Irgacure 651," made by Ciba Specialty Chemicals), and 2 weight parts polyisocyanate compound (trade name "Coronate L," made by Nippon Polyurethane Industry), which gave a UV-curing acrylic adhesive solution.
An adhesive sheet was obtained in the same manner as in Example 1 except that the UV curable adhesive solution was coated to an adhesive layer thickness of 15 µm.

### Example 4

48 weight parts methyl acrylate, 48 weight parts 2-ethylhexyl acrylate, and 4 weight parts of 2-hydroxyethyl acrylate were copolymerized by a standard method in toluene to obtain a solution containing an acrylic copolymer with a weight average molecular weight of 500,000.
To this solution containing the acrylic copolymer were added 5 weight parts polyisocyanate compound (trade name "Coronate L," made by Nippon Polyurethane Industry), which gave a UV-curing acrylic adhesive solution.
An adhesive sheet was obtained in the same manner as in Example 1 except that the UV curable adhesive solution was coated to an adhesive layer thickness of 5 µm on the above base film.

### Example 5

An adhesive sheet was obtained in the same manner as in Example 1 except that 5 weight parts Coronate L in the adhesive solution, and the UV curable adhesive solution was coated to an adhesive layer thickness of 15 µm on the above base film.

### Example 6

An adhesive sheet was obtained in the same manner as in Example 1 except that the UV curable adhesive solution was coated to an adhesive layer thickness of 30 µm on the above base film.

### Example 7

An adhesive sheet was obtained in the same manner as in Example 4 except that the UV curable adhesive solution was coated to an adhesive layer thickness of 30 µm.

### Example 8

48 weight parts methyl acrylate, 48 weight parts 2-ethylhexyl acrylate, and 4 weight parts of 2-hydroxyethyl acrylate were copolymerized by a standard method in toluene to obtain a solution containing an acrylic copolymer with a weight average molecular weight of 500,000.
To this solution containing the acrylic copolymer were added 10 weight parts polyisocyanate compound (trade name "Coronate L," made by Nippon Polyurethane Industry), which gave a UV-curing acrylic adhesive solution.
An adhesive sheet was obtained in the same manner as in Example 1 except that the UV curable adhesive solution was coated to an adhesive layer thickness of 5 µm on the above base film.

### Example 9

An adhesive sheet was obtained in the same manner as in Example 1 except that an adhesive layer thickness was 30 µm.

### Comparative Example 1

An adhesive sheet was obtained in the same manner as in Example 5 except that an adhesive layer thickness was 30 µm.

### (Measurement of Adhesive Layer Thickness)

The adhesive sheets obtained in the examples and comparative example were cut with a microtome, the cut surfaces were treated by Pt-Pd sputtering, and secondary electron images were observed by SEM (Hitachi: S-4800) to measure the adhesive layer thickness D (see Figure 1).

### (Measurement of Angle of Contact of Water Relative to Adhesive Layer Surface)

An image processing type of contact angle meter (tradename FACE, contact angle meter, CA-X model) was used. The adhesive layer side of the adhesive sheets obtained in the examples and comparative examples was positioned on top, and drops of water were allowed to fall from a syringe onto the adhesive layer surface. The angle of contact was determined after the drops had been allowed to fall for 1 minute.

### (Measurement of Tensile Strength of Adhesive Layer)

A universal tension test meter was used. The adhesive used in the examples and comparative examples was formed on release paper, and the strength at break (chuck interval 10 mm, width 10 mm, pulling rate 300 mm/min) was divided by the cross section area prior to measurement to come up with the tensile strength.

### (Condition of Dicing)

Silicon wafers polished to 100 µm-thick were diced after adhering them to adhesive sheets obtained in the example and comparative example according to the following conditions.
Laser wavelength: 532 nm,
Dicing speed: 50 mm/s, 70 mm/s
Laser diameter: 50 µm,
Water jet pressure: 8 MPa,
Chip size: 1 mm × 1 mm,
Wafer size: 13.7 cm (5 inch),
⊚: The silicon wafer was completely diced and all dicing line adhesive was broken up, with good water drainage and virtually no water collection on the surface of chips.
○: The silicon wafer was completely diced, with good water drainage and virtually no water collection on the surface of chips, but some of the dicing line adhesive was not broken up
△: The water drainage was poor, water collected on virtually the entire surface of the chips, and parts of the silicon wafer were not diced
×: The water drainage was poor, water collected on virtually the entire surface of the chips, and virtually none of the silicon wafer was diced.
A rating of ⊚ or ○ was good, and a rating of △ or × was bad.

**Table 1**

| Ex. | Adhesive Layer Thickness D (µm) | Contact Angle (°) | Fracture Strength (MPa) | Water Drainage | |
|---|---|---|---|---|---|
| | | | | 50mm/s | 70mm/s |
| 1 | 5 | 70 | 0.5 | ⊚ | ⊚ |
| 2 | 15 | 70 | 0.5 | ⊚ | ⊚ |
| 3 | 15 | 110 | 0.3 | ⊚ | ○ |
| 4 | 5 | 105 | 0.8 | ⊚ | ○ |
| 5 | 15 | 70 | 1.2 | ⊚ | ○ |
| 6 | 30 | 70 | 1.2 | ○ | ○ |
| 7 | 30 | 105 | 0.8 | ○ | △ |
| 8 | 5 | 105 | 1.2 | ○ | △ |
| 9 | 30 | 70 | 0.5 | ○ | △ |
| Comp.Ex.1 | 30 | 105 | 1.2 | × | × |

It is clear from table 1, when the adhesive layer thickness, adhesive layer tensile strength, and angle of contact of water on the adhesive layer surface were all within the specified ranges, the water drainage was exceptionally good, no water collected on the surface of the silicon wafer, and the wafer was always completely diced into chips. The machining precision was also good, with no chipping or scattering of chips, etc. All of the dicing line adhesive layer was also broken up, allowing chips and the like to be readily detached, without any defects resulting from their detachment, etc., during pick up after dicing.

Furthermore, if any of the adhesive layer thickness, adhesive layer tensile strength, or angle of contact of water on the adhesive layer surface was outside the specified ranges, some of the adhesive layer left over after being broken up.
When, on the other hand, the adhesive layer thickness, adhesive layer tensile strength, and angle of contact of water on the adhesive layer surface were all outside the specified ranges, the result was inadequate water drainage, the inability to properly dice the wafer, or scattering of chips and the like.

### [INDUSTRIAL APPLICABILITY]

The adhesive sheet for water jet laser dicing of the present invention can be utilized in a wide range of applications in which a material is diced with a laser beam guided by a liquid jet, that is, it can be applied not only to semiconductor-related materials and the like (such as semiconductor wafers, BGA packages, printed wiring boards, ceramic boards, glass member for liquid crystal devices, sheet materials, circuit boards, glass substrates, ceramics substrates, metal substrates, light-emitting and light-receiving element substrates for semiconductor laser, MEMES substrates, semiconductor packages), but to all kinds of materials.

### BRIEF DESCRIPTION OF THE DRAWINGS

FIG. 1 is simplified cross sectional view of the adhesive sheet of laser processing of the present invention.

### LEGEND

- 10: adhesive sheet for water jet laser dicing
- 11: adhesive layer
- 12: base film

## Claims

1. An adhesive sheet for water jet laser dicing, comprising an adhesive layer laminated on a base film,
the base film has a perforation, and the adhesive layer has a thickness of 0.1 to 20µm.

2. The adhesive sheet according to Claim 1, wherein the adhesive layer had a tensile strength of 1 MPa or more.

3. The adhesive sheet according to Claim 1 or 2, wherein the adhesive layer has an angle of contact of water of no more than 90 degrees relative to the surface thereof.

4. An adhesive sheet for water jet laser dicing, comprising an adhesive layer laminated on a base film,
the adhesive layer had a tensile strength of 1 MPa or more.

5. The adhesive sheet according to Claim 4, wherein the adhesive layer has an angle of contact of water of no more than 90 degrees relative to the surface thereof.

6. An adhesive sheet for water jet laser dicing, comprising an adhesive layer laminated on a base film,
the adhesive layer has an angle of contact of water of no more than 90 degrees relative to the surface thereof.

7. The adhesive sheet according to any one of Claims 1 to 6, wherein the adhesive is a type that is cured by an energy radiation.

8. The adhesive sheet according to any one of Claims 1 to 6, wherein the base film is a mesh film.
